# EUROPEAN PATENT APPLICATION

(11) **EP 4 750 246 A1**
(43) Date of publication of application: **27.05.2026**
(21) Application number: 25175224.2
(22) Date of filing: 09.05.2025
(51) Int. Cl.: H10D 1/47, H10D 84/05, H10D 1/40, H10D 30/47, H10D 62/824, H10D 84/80

(54) **RESISTOR FOR III-V SEMICONDUCTOR DEVICE**

(30) Priority: 25.11.2024 US 202418958677
(71) Applicant: GlobalFoundries U.S. Inc., Malta, NY 12020 (US)
(72) Inventor: Raghunathan, Uppili S., Essex Junction, VT 05452 (US); Raman, Ajay, Essex Junction, VT 05452 (US); Rassel, Richard J., Essex Junction, VT 05452 (US)
(74) Representative: Grünecker Patent- und Rechtsanwälte PartG mbB

(57) **Abstract**

A resistor including a first current transport level, a second current transport level, and a vertical interconnect resistor that couples the first and second current transport levels. The vertical interconnect resistor includes a doped conductive layer including one of indium gallium nitride (InGaN) and a doped polysilicon. The first and second current levels may include a number of current level islands that can be coupled in a lateral serpentine fashion and a vertical serpentine fashion to control a length and resistance value of the resistor. The resistor can be employed with III-V semiconductor devices and takes up less areal space than current resistors.

## Description

This application was made with government support under contract number HQ027790700 awarded by the Department of Defense. The US government has certain rights in the invention.

### BACKGROUND

The present disclosure relates to III-V semiconductor devices. More particularly, the present disclosure relates to a resistor for a III-V semiconductor device.

III-V semiconductor devices, such as high electron mobility transistors (HEMTs) and metal-insulator-semiconductor HEMTs (MISHEMTs), have emerged as a leading technology for radio frequency (RF) and millimeter wave (mmWave) (e.g., 3-300GHz) wireless applications. Resistors are used in integrated circuit (IC) structure with, for example, HEMTs, for a number of purposes. For example, in radio frequency (RF) applications such as power amplifiers, resistors may be provided to help regulate voltage flowing in the IC structure to avoid overloads. Resistors in integrated circuit (IC) devices can use a lot of space, so it is advantageous to minimize their footprint.

### SUMMARY

All aspects, examples and features mentioned below can be combined in any technically possible way.

An aspect of the disclosure provides a resistor, comprising: a first current transport level; a second current transport level; and a vertical interconnect resistor that couples the first and second current transport levels, the vertical interconnect resistor including a doped conductive layer including one of indium gallium nitride (InGaN) and a doped polysilicon.

An aspect of the disclosure provides a resistor, comprising: a first current transport level; a second current transport level; and a vertical interconnect resistor that couples the first and second current transport levels, the vertical interconnect resistor including a doped conductive layer including one of indium gallium nitride (InGaN) and a doped polysilicon, wherein the first current transport level includes a plurality of first current transport islands, each first current transport island including one of: a two-dimensional electron gas (2DEG) region at an interface between a barrier layer and a channel layer of a plurality of III-V semiconductor layers and a portion of the doped conductive layer over the channel layer, and wherein each first current transport island extends in a first direction, wherein the second current level includes a plurality of second current transport islands, each second current transport island including one of a base layer of the plurality of III-V semiconductor layers and a portion of the doped conductive layer in the base layer of the plurality of III-V semiconductor layers, and wherein each first current transport island is coupled to at least one second current transport island by the doped conductive layer of a respective vertical interconnect resistor and each second current transport island is coupled to at least one first current transport island by the doped conductive layer of a respective vertical interconnect resistor, and wherein each second current transport island extends in a second direction perpendicular to the first direction, wherein the plurality of first current transport islands, the plurality of second current transport islands and the vertical interconnect resistors coupled therebetween are arranged in a lateral serpentine fashion and a vertical serpentine fashion.

An aspect of the disclosure provides a method, comprising: forming a first current transport level; forming a second current transport level at a different level than the first current level; and forming a vertically interconnect resistor connecting the first current transport level to the second current transport level using a doped conductive layer including one of an indium gallium nitride (InGaN) and a doped polysilicon.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a schematic top-down view of a resistor according to embodiments of the disclosure;
FIG. 2 shows a cross-sectional view along view line X-X in FIG. 1;
FIG. 3 shows a cross-sectional view along view line Y-Y in FIG. 1;
FIG. 4 shows a cross-sectional view of a preliminary structure in a method of forming a resistor according to embodiments of the disclosure;
FIG. 5 shows a cross-sectional view of forming dopant regions in a method of forming a resistor according to embodiments of the disclosure;
FIGS. 6A-B show cross-sectional views of forming first current transfer islands in a method of forming a resistor according to embodiments of the disclosure;
FIGS. 7A-B show cross-sectional views of forming a trench for a vertical interconnect resistor in a method of forming a resistor according to embodiments of the disclosure;
FIGS. 8A-B show cross-sectional views of forming a vertical interconnect resistor in a method of forming a resistor according to embodiments of the disclosure;
FIGS. 9A-B show cross-sectional views of forming a vertical interconnect resistor with dielectric sidewalls in a method of forming a resistor according to embodiments of the disclosure;
FIG. 10 shows a cross-sectional view of a resistor according to embodiments of the disclosure;
FIG. 11 shows a cross-sectional view of a resistor according to other embodiments of the disclosure; and
FIG. 12 shows a cross-sectional view of a resistor according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include a resistor including a first current transport level, a second current transport level, and a vertical interconnect resistor that couples the first and second current transport levels. The vertical interconnect resistor may include a doped conductive layer including one of indium (doped) gallium nitride (InGaN) and a doped polysilicon. The first and second current levels may include a number of current level islands that can be coupled in a lateral serpentine fashion and a vertical serpentine fashion to control a length and resistance value of the resistor. The resistor can be employed with III-V semiconductor devices and takes up less space than current resistors.

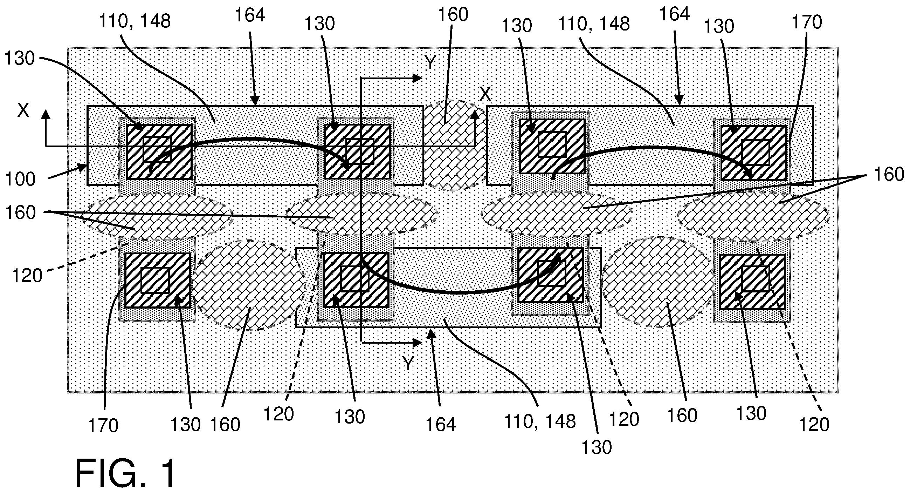

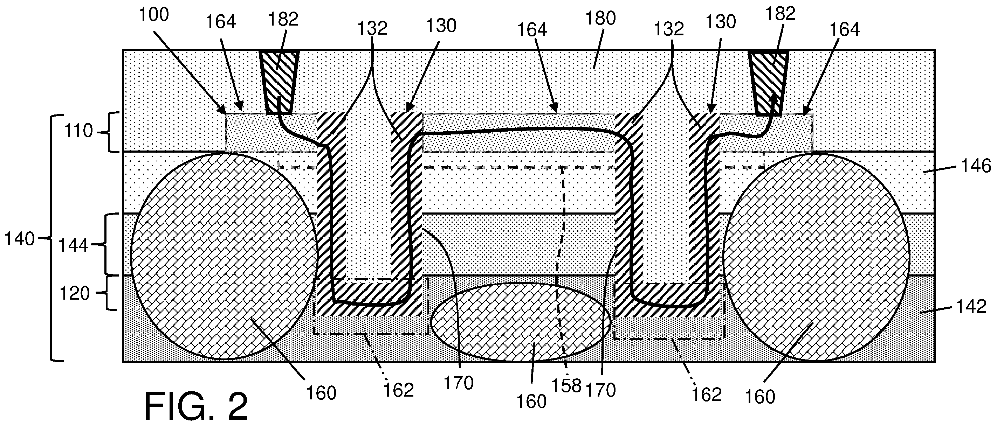

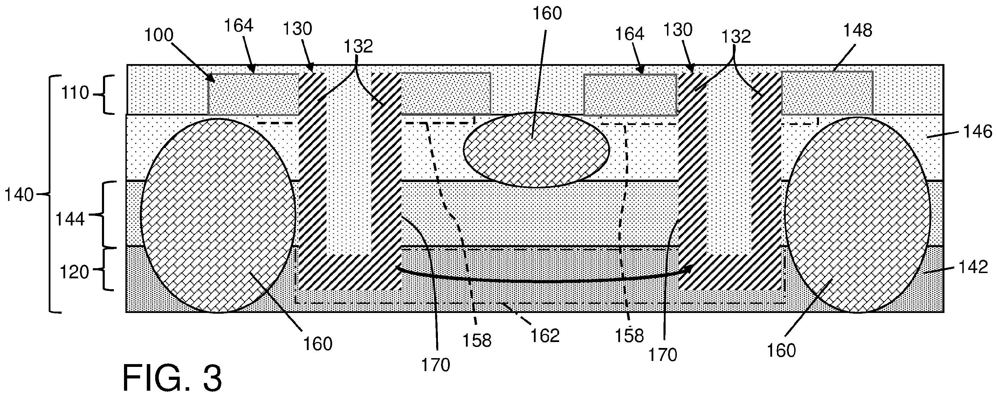

FIG. 1 shows a schematic top-down view of a resistor 100 according to embodiments of the disclosure. FIG. 2 shows a cross-sectional view of resistor 100 along view line X-X in FIG. 1, and FIG. 3 shows a cross-sectional view of resistor 100 along view line Y-Y in FIG. 1.

As an introduction, as shown in FIGS. 1-3, resistor 100 includes a first current transport level 110, a second current transport level 120, and a vertical interconnect resistor 130 that couples first and second current transport levels 110, 120. "Current transport level," as used herein, indicates a resistive element that can be chained together with vertical interconnect resistors (described herein) to customize an overall resistance of resistor 100. As will be described in greater detail, vertical interconnect resistor 130 includes a doped conductive layer 132 including one of indium (doped) gallium nitride (InGaN) and a doped polysilicon.

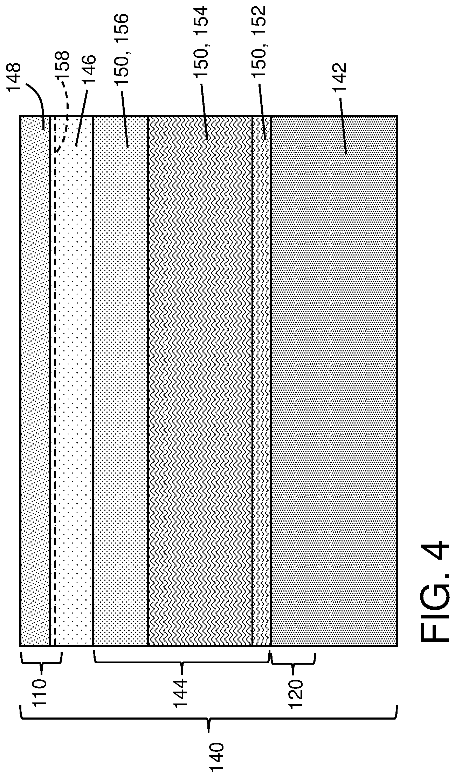

FIGS. 4-9B show cross-sectional views of a method of forming resistor 100. FIG. 4 shows forming a preliminary structure including a plurality of III-V semiconductor layers 140 of a substrate. III-V semiconductor layers 140 may include any layers typically used to form a III-V semiconductor device, e.g., a high electron mobility transistor (HEMT) or a metal-insulator-semiconductor HEMT (MISHEMT) (not shown). More particularly, III-V semiconductor layers may include multiple epitaxially grown III-V semiconductor layers. Those skilled in the art will recognize that a III-V semiconductor refers to a compound obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). More particularly, FIG. 4 shows forming a plurality of III-V semiconductor layers 140 including a semiconductor base layer 142, a channel layer 146 over semiconductor base layer 142, and a barrier layer 148 over channel layer 146. A two-dimensional electron gas (2DEG) region 158 is at an interface between barrier layer 148 and channel layer 146. More particularly, plurality of III-V semiconductor layers 140 may include semiconductor base layer 142 (hereafter "base layer 142"), a plurality of buffer layers 144 over base layer 142, channel layer 146 over buffer layers 144, and barrier layer 148 over channel layer 146.

With further regard to the specific layers of plurality of III-V semiconductor layers 140, base layer 142 can be, for example, a silicon or silicon-based base substrate (e.g., a silicon carbide (SiC) substrate), a sapphire substrate, a III-V semiconductor base substrate (e.g., a gallium nitride (GaN) substrate or some other suitable III-V semiconductor substrate), or any other suitable substrate for a III-V semiconductor device. In certain embodiments, base layer 142 may be intrinsic (undoped) III-V semiconductor such as gallium nitride (u-GAN), or it may include a III-V semiconductor with n-type dopant such as but not limited to silicon and/or silicon germanium, e.g., gallium nitride doped with silicon and/or silicon germanium.

Buffer layers 144 can be employed to facilitate growth of channel layer 146 and to provide for lattice constants of base layer 142 below and channel layer 146 above. (Note, in

FIGS. 2, 3 and 10-12, the individual buffer layers are not shown for clarity). Buffer layer(s) 144 can be doped or undoped. If doped, buffer layers 144 may include, for example, a plurality of p-type III-V semiconductor layers 150 (FIG. 4) under channel layer 146. More particularly, buffer layers 144 may include a nucleation layer 152 over base layer 142, a plurality of doped III-V semiconductor buffer layers 154 over nucleation layer 152, and an uppermost doped III-V semiconductor buffer layer 156. Uppermost doped III-V semiconductor buffer layer 156 may include gallium nitride and a p-type dopant such as carbon. Hence, uppermost buffer layer 156 may be referenced as a "C-GaN layer". Alternatively, buffer layers 144 can include any other material suitable for use as a buffer layer for a III-V semiconductor device.

Channel layer 146 may also include a III-V semiconductor such as gallium nitride. Alternatively, channel layer 146 can be made of any other III-V semiconductor compound suitable for use as a channel layer in a HEMT or MISHEMT. During epitaxial formation of channel layer 146 it may be unintentionally lightly doped with silicon, making it slightly n-type.

Barrier layer 148 can have a band gap that is wider than the bandgap of channel layer 146 for the device channel. In certain embodiments, barrier layer 148 can be an aluminum gallium nitride (AlGaN) barrier layer or a barrier layer of any other material suitable for use as a barrier layer in a III-V semiconductor device. Those skilled in the art will recognize that barrier layer 148 and channel layer 146 materials can be selected so that a heterojunction is formed at the interface between the two layers, thereby resulting in the formation of two-dimensional electron gas (2DEG) region 158 in channel layer 146 (see dashed box). Although a HEMT or MISHEMT is not shown, it is understood that 2DEG region 158 in channel layer 146 can provide the conductive pathway for the drifting of charges between a source terminal and a drain terminal under control of a gate (with or without a field plate) over/through barrier layer 148 to control operation of 2DEG region 158 in channel layer 146.

For purposes of illustration, the figures and the description depict the epitaxially grown layers (e.g., certain layers of buffer layers 144; channel layer 146 and uppermost buffer layer 156) as being single layered structures (i.e., comprising one layer of buffer material, one layer of channel material and one layer of barrier material). However, it should be understood that, alternatively, any one or more of the epitaxially grown layers could be multi-layered structures (e.g., comprising multiple sub-layers of different buffer materials, multiple sub-layers of different III-V semiconductor channel materials and/or multiple sub-layers of different barrier materials). The various dopants described herein may be added using any appropriate doping process, for example, during the epitaxial growth process of the layers.

Although not shown, one or more passivation layers may be over barrier layer 148, e.g., two passivation layers with an etch stop layer therebetween. The passivation layers may include one or more layers of any appropriate passivation material such as but not limited to aluminum oxide, silicon nitride and/or silicon oxide. In certain embodiments, the passivation layers may include any interlevel or intralevel dielectric material including inorganic dielectric materials, organic dielectric materials, or combinations thereof. In this case, suitable passivation layer materials may include but are not limited to: silicon oxide; silicon nitride; carbon-doped silicon dioxide materials; fluorinated silicate glass (FSG); organic polymeric thermoset materials; silicon oxycarbide; SiCOH dielectrics; fluorine doped silicon oxide; spin-on glasses; silsesquioxanes, including hydrogen silsesquioxane (HSQ), methyl silsesquioxane (MSQ) and mixtures or copolymers of HSQ and MSQ; benzocyclobutene (BCB)-based polymer dielectrics, and any silicon-containing low-k dielectric. The etch stop layer may be provided between the passivation layers to protect the lower passivation layer during etching processes. The etch stop layer may include any now known or later developed etch stop material such as silicon nitride. The passivation layers and etch stop layer may be formed using any appropriate deposition technique, e.g., chemical vapor deposition.

FIG. 4 also shows initial steps of forming first current transport level 110 and second current transport level 120 at a different level than first current level 110. For example, 2DEG region 158 is formed for first current transport level 110, and base layer 142 is formed for second current transport level 120. Current transfer levels 110, 120 will incur further processing to complete, as will be described herein.

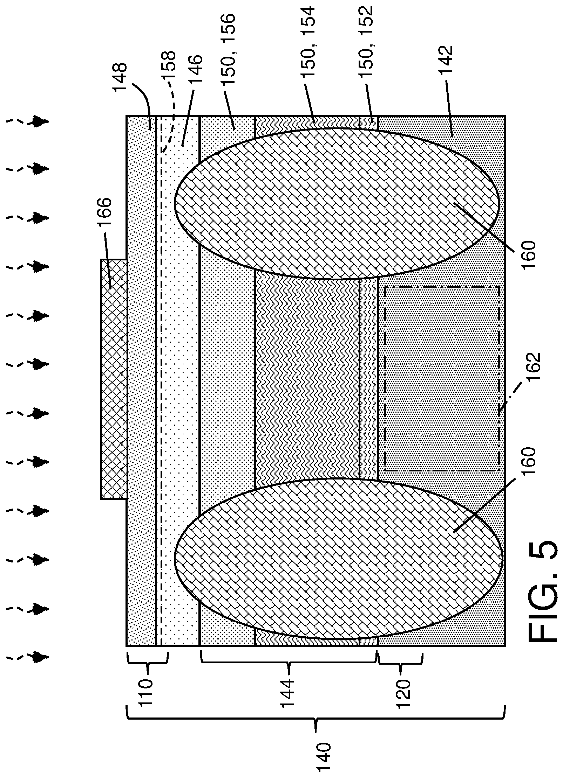

FIG. 5 shows forming more of current transfer levels 110, 120. More particularly, FIG. 5 shows implanting a current blocking dopant (creating dopant region(s) 160) into at least base layer 142 to define a second current transport island 162 (dashed box) in base layer 142. Current blocking dopant prevents current from flowing anywhere in which it is present, e.g., in base layer 142 or any other layer of plurality of III-V semiconductor layers 140. As shown in FIGS. 1 and 3, the current blocking dopant may also be optionally used to form first current transport level island(s) 164 for first current transfer level 110. The current blocking dopant may include any now known or later developed dopant that prevents current flow in the desired layers, e.g., base layer 142, buffer layers 144 and perhaps channel layer 146. The doping process can be carried out using any now known or later developed doping process, e.g., ion implantation and/or doping during epitaxial formation of the layers of plurality of III-V semiconductor layers 140. In certain embodiments, the current blocking dopant may include nitrogen; however, other dopants are possible. Where ion implantation is used, the location of dopant regions 160 can be controlled by, for example, providing a patterned mask 166 (FIG. 5) or patterning barrier layer 148 prior to the dopant implanting. Where ion implantation is used with nitrogen, nitrogen implant regions are formed. The depth and height of dopant regions 160 can be controlled in a known fashion, e.g., by controlling the dopant concentration during epitaxial growth and the location of epitaxial growth; controlling ion implanting parameters such as duration, strength and direction; or controlling other doping process parameters. Once dopant regions 160 are formed, where used, mask 166 may be removed using any now known or later developed process appropriate for the mask material used. As the methodology to control dopant region 160 formation is well known in the field, no further details are provided so the reader can focus on the salient points of the disclosure.

Dopant regions 160 can be used in any location, have any upper and lower extent, and any latera extent, to create the desired current transport islands 162, 164. In FIG. 5, dopant region(s) 160 for second current transport islands 162 are shown extending vertically through layers 142, 144, 146 of plurality of III-V semiconductor layers 140, but that arrangement may not be necessary in all cases. For example, formation of second current level island(s) 162 may only require dopant region(s) 160 in base layer 142. Where provided, nitrogen dopant makes base layer 142 non-conductive. In addition, dopant regions 160 are shown in FIG. 1 and 3 as being within channel layer 146 to further define first current transport islands 164 along with, as will be described, the patterning of barrier layer 148. Nitrogen dopant destroys 2DEG region 158, making channel layer 146 non-conductive where it is present. (Note, the schematic top-down of FIG. 1 shows dopant regions 160 regardless of their depth. It is understood that dopant regions 160 at different depths would not all be visible in a top-down view. The cross-sectional shapes of dopant regions 160 have been illustrated as oval or circular for clarity purposes, it is recognized that they can have a variety of different cross-sectional shapes depending on the topography in which they are formed.)

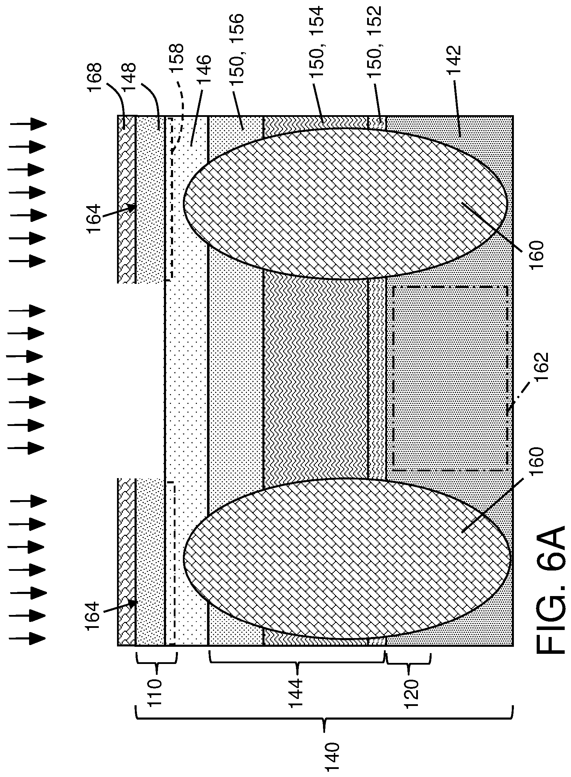

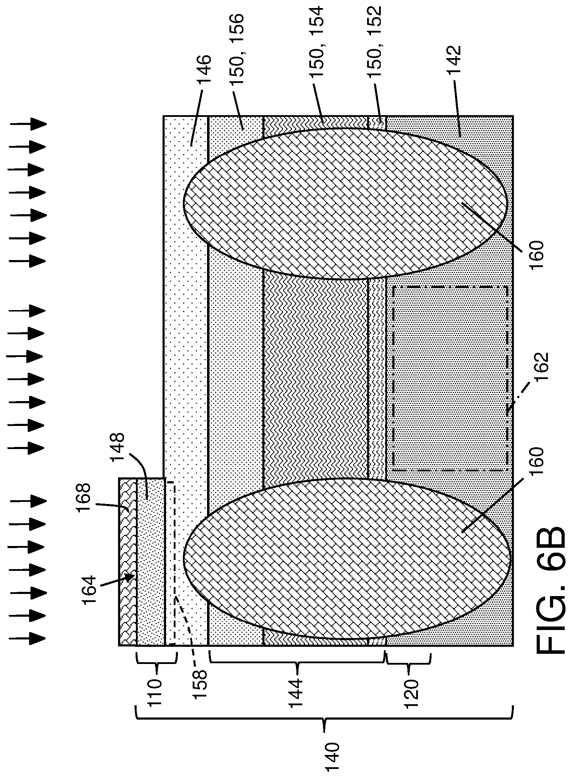

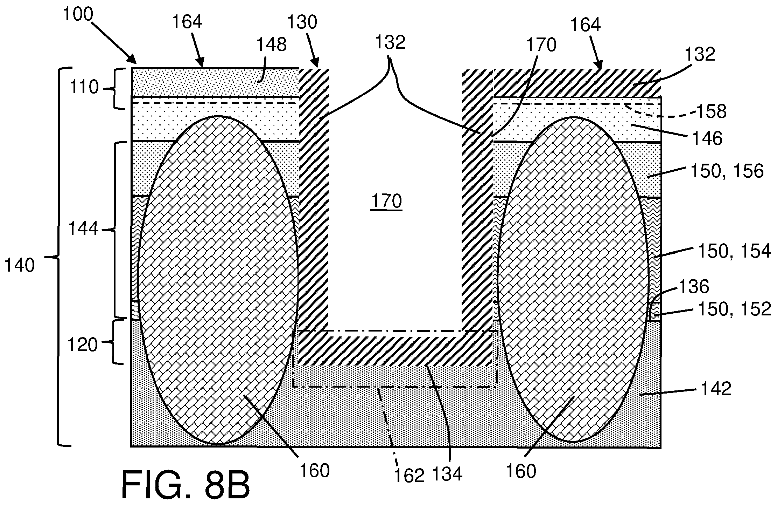

As will be further described, first current transport islands 164 may include a portion of 2DEG region 158 as defined by barrier layer 148 over channel layer 146 (see, e.g., FIGS. 2, 3 and 8A) and/or it/they may be part of doped conductive layer 132 over channel layer 146 (see, e.g., FIG. 8B). In certain embodiments, at least one of first current transport islands 164 includes a portion of 2DEG region 158 as defined by barrier layer 148 over channel layer 146. FIG. 6A shows forming a pair of spaced first current transport islands 164 for first current transport level 110 where both first current transport islands 164 include a portion of 2DEG region 158. FIG. 6B shows forming first current transport island 164 for first current transport level 110 where one island 164 includes a portion of 2DEG region 158 and the other to-be-formed island 164 includes part of doped conductive layer 132. In either event, barrier layer 148 may be patterned using any now known or later developed patterning process appropriate for the material of barrier layer 148, e.g., aluminum gallium nitride. For example, a mask 168 may be patterned to expose portions of barrier layer 148 to be removed, an etch performed to remove the exposed portions, and mask 168 removed. As the methodology to pattern a layer in a semiconductor device is well known in the field, no further details are provided so the reader can focus on the salient points of the disclosure. As shown in FIG. 1, barrier layer 148 can be patterned to form practically any arrangement of first current transport islands 164, e.g., three spaced and laterally overlapping islands.

In alternative embodiments, forming dopant regions 160 may not be performed until after barrier layer 148 is patterned, as shown in FIGS. 6A-B. The process is the same as described previously herein relative to FIG. 5 except the patterned barrier layer 148 may direct or assist in directing the forming of dopant regions 160 with or without the use of additional mask(s), like mask 166 in FIG. 5.

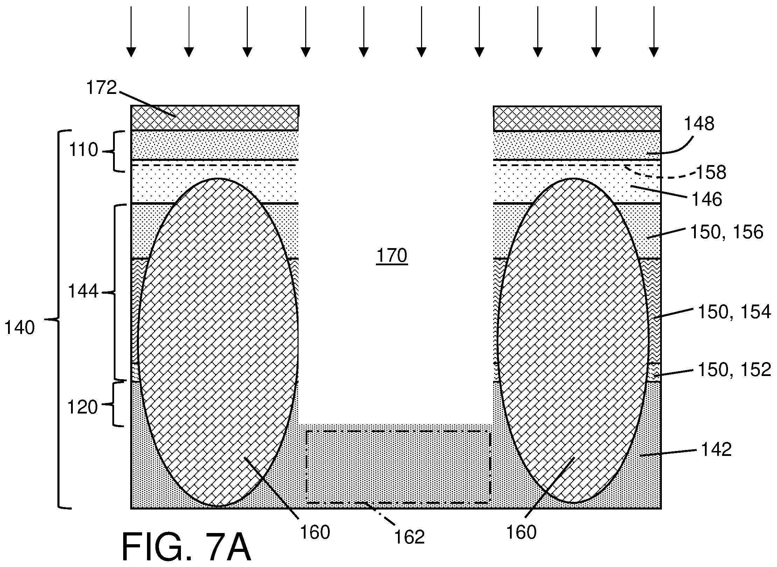

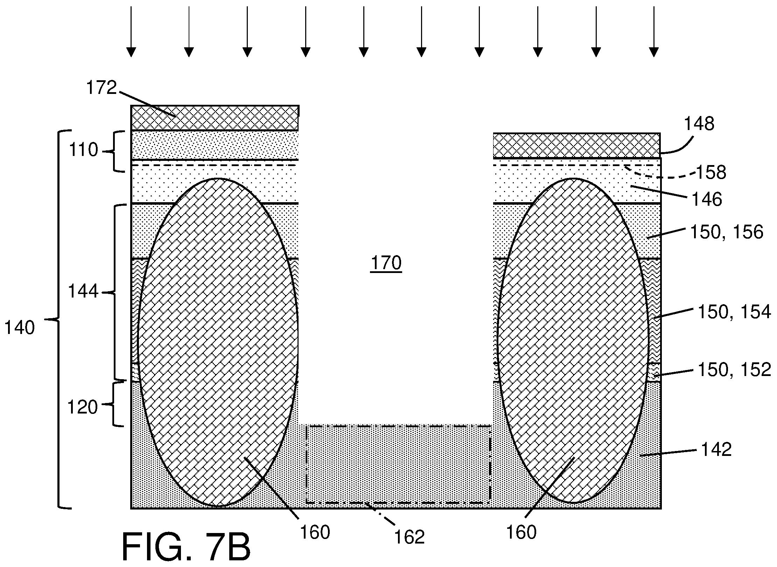

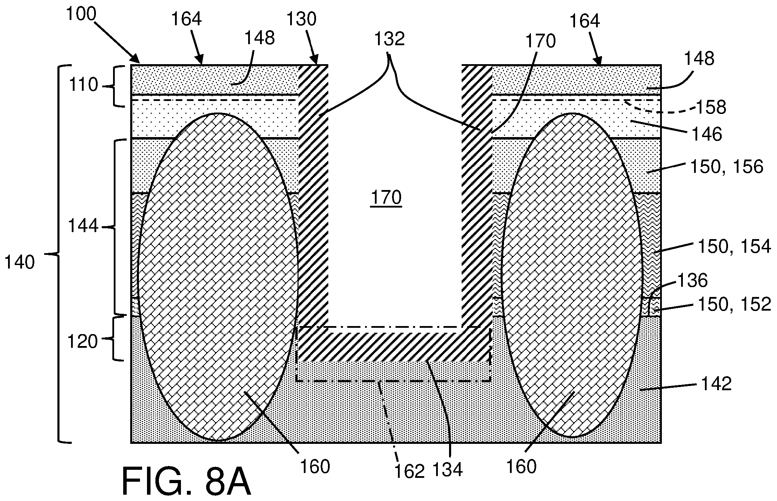

FIGS. 7A-B and 8A-B show forming vertical interconnect resistor 130 connecting first current transport level 110 to second current transport level 120 using doped conductive layer 132 including one of an indium (doped) gallium nitride (InGaN) and a doped polysilicon. FIGS. 7A-B show forming a trench 170 to base layer 142 from the FIGS. 6A-B embodiments, respectively. Trench 170 may be formed using any now known or later developed technique. For example, a patterned mask 172 may be formed, an etch performed to remove layers of plurality of III-V semiconductor layers 140 to reach to, or enter into, base layer 142, and then mask 172 may be removed. While trench 170 is shown reaching into base layer 142, this arrangement may not be necessary in all cases, e.g., trench 170 may just extend to an upper surface of base layer 142. As the methodology to form trenches in a semiconductor device is well known in the field, no further details are provided so the reader can focus on the salient points of the disclosure.

FIGS. 8A-B show epitaxially growing doped conductive layer 132 in trench 170. As noted, in certain embodiments, doped conductive layer 132 may include indium gallium nitride. In other embodiments, doped conductive layer 132 may include polysilicon, i.e., doped with n-type dopants such as but not limited to arsenic and/or phosphorus, or doped with p-type dopants such as but not limited to boron, depending on the polarity of the resistor. Nonetheless, doped conductive layer 132 extends vertically along a sidewall of trench 170 extending through plurality of III-V semiconductor layers 140. As shown in FIGS. 8A-B, a bottom portion 134 of doped conductive layer 132 in trench 170 (and bottom of trench 170) may be below and an upper surface 136 of base layer 142 of plurality of III-V semiconductor layers 140. As shown in FIG. 8B, where a portion of barrier layer 148 has been removed from over channel layer 146 (right side), doped conductive layer 132 may grow on channel layer 146 to form a first current transport island 164. In this example, a first current transport island 164 (left side) includes 2DEG region 158 at an interface between barrier layer 148 and channel layer 146 of plurality of III-V semiconductor layers (substrate) 140 and another first current transport island 164 (right side) includes a portion of doped conductive layer 132 over channel layer 146. The two islands 164 are spaced apart and will be electrically isolated by a later formed interlevel dielectric (ILD). Hence, in this example, forming a pair of spaced first current transport islands 164 for first current transport level 110 includes forming at least one of the pair of first current transport islands 164 (left side) including the portion of 2DEG region 158 and forming at least one other of the pair first current transport islands 164 (right side) as a portion of doped conductive layer 132 over channel layer 146. In contrast, as shown in FIG. 8A, both first current transport islands 164 shown include 2DEG region 158 at an interface between barrier layer 148 and channel layer 146 of plurality of III-V semiconductor layers (substrate) 140. Vertical interconnect resistor 130 is electrically coupled to first current transport island(s) 164 to form resistor 100.

Forming doped conductive layer 132 for vertical interconnect resistor 130 may also form part of second current transport island(s) 162. More particularly, where current (see dark arrows in FIG. 1-3, 10-12) does not travel through base layer 142, it may flow through doped conductive layer 132 in bottom of trench 170. Hence, second current transport level 120 and second current transport islands(s) 162 thereof may include portions of base layer 142 and/or doped conductive layer 132 in bottom of trench 170. Based on the material of base layer 142, second current level 120 may include at least one of an intrinsic III-V semiconductor of base layer 142, a doped III-V semiconductor of base layer 142, and a portion of the doped conductive layer 132. It will be recognized that current also travels vertically within doped conductive layer 132.

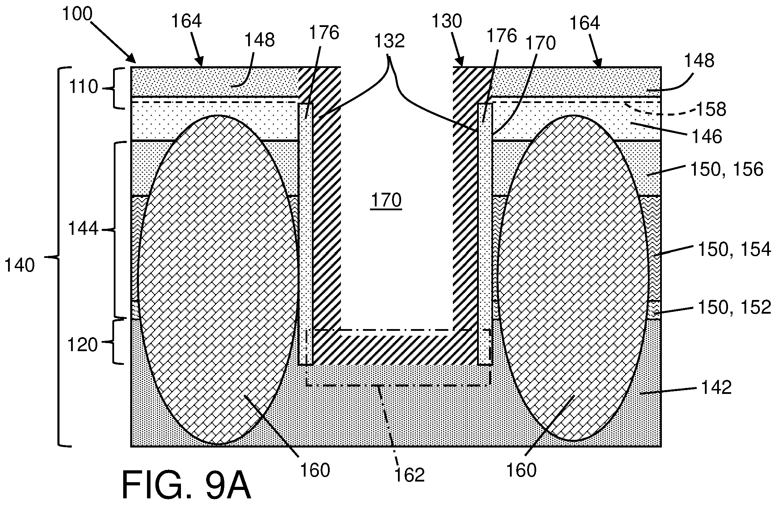

FIGS. 9A-B show a cross-sectional view of resistor 100 according to an alternative embodiment. In certain embodiments, prior to forming doped conductive layer 132 (FIGS. 8A-B), the method may include forming a dielectric layer 176 on sidewalls of trench 170 below 2DEG region 158. That is, dielectric layer 176 is formed prior to epitaxially growing doped conductive layer 132. Dielectric layer 176 may be provided to serve as a better lateral isolation between conductive layer 132 and plurality of III-V semiconductor layers 140 in addition to dopant region(s) 160. Dielectric layer 176 may include any now known or later developed dielectric material such as but not limited to silicon oxide. Dielectric layer 176 may be formed by depositing the material and then etching it back so an upper end thereof is below 2DEG region 158, so doped conductive layer 132 can electrically contact first current transport islands 164, e.g., 2DEG region 158, to form resistor 100. In this manner, doped conductive layer 132 is electrically connected to 2DEG region 158, where the latter exists, and to first current transport island 164 formed thereby.

Subsequent steps of the method may include forming any necessary electrical interconnect layers to resistor 100. For example, as shown in FIG. 2, one or more ILD layers 180 may be deposited and contacts 182 formed to first current transport level 110, e.g., one or more first current transport islands 164. As the formation of contacts and metal wire interconnect layers are well known in the art no further details are provided so the reader can focus on the salient parts of the disclosure.

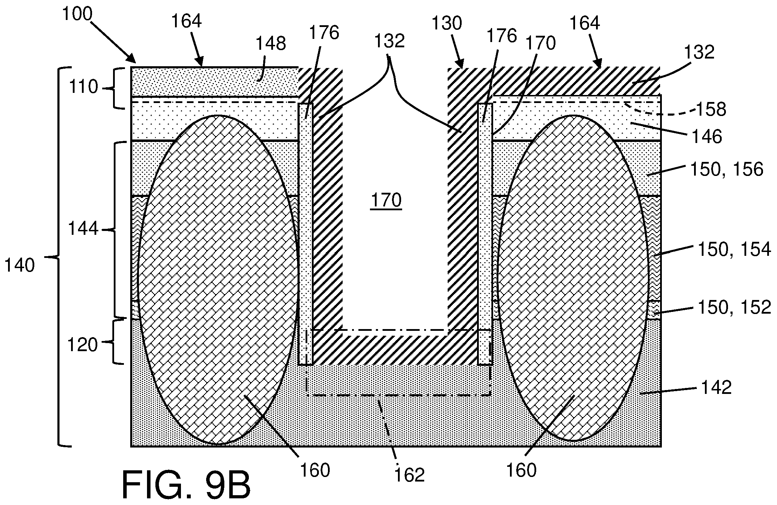

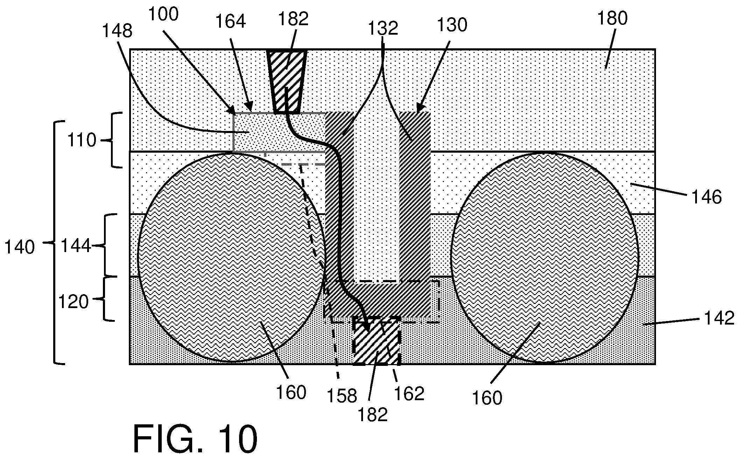

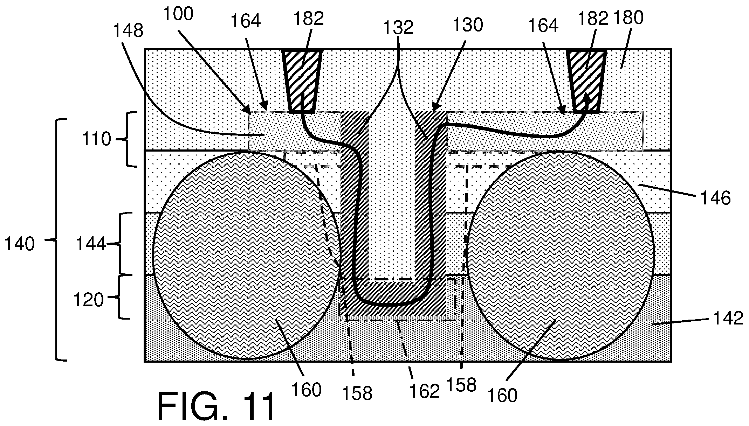

Various embodiments of resistor 100 that can be formed using the methods as described herein will now be described. Resistor 100 may include at least one first current transport island(s) 164 coupled to second current transport level 120 by doped conductive layer 132 of the vertical interconnect resistor 130. In a simple form, as shown in FIG. 10, resistor 100 may include a single first current transport island(s) 164 (with 2DEG region 158) coupled to second current transport level 120 by doped conductive layer 132 of the vertical interconnect resistor 130. A contact 182 may be made to first current transfer island 164 from above and a contact 182 may be made to second current transfer island 162 from below. In other embodiments, as shown in FIG. 11, resistor 100 includes at least two laterally isolated first current transport islands 164 coupled to second current transport level 120 by doped conductive layer 132 of vertical interconnect resistor 130. A contact 182 may be made to each first current transfer island 164 from above. While FIG. 11 shows first current transfer islands 164 as including 2DEG region 158, it is understood that one of the first current transfer islands 164 could include doped conductive layer 132 over channel layer 146, as shown in FIGS. 8B and 9B.

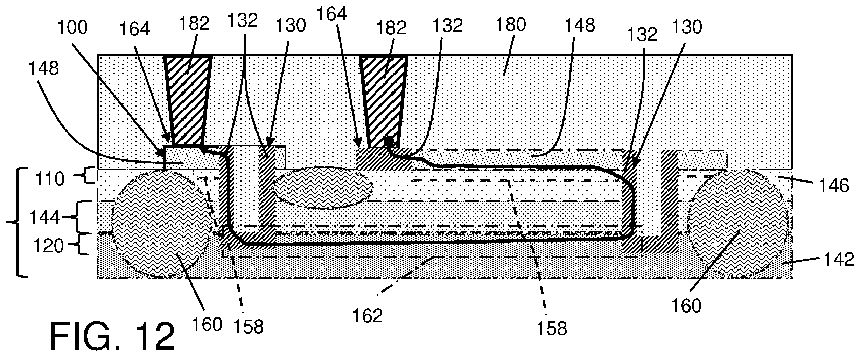

Resistor 100 includes first current transport level 110 that includes at least one first current transport island 164. Each first current transport island 164 includes one of: as shown in FIGS. 1-3, 10, 11, 2DEG region 158 at an interface between barrier layer 148 and channel layer 146 of plurality of III-V semiconductor layers 140 and, as shown in the right side of FIGS. 8B and 9B, a portion of doped conductive layer 132 over channel layer 146. In certain embodiments, as shown on the right side of FIG. 12, first current transport island(s) 164 may include both 2DEG region 158 at an interface between barrier layer 148 and channel layer 146 and a portion of doped conductive layer 132 over channel layer 146. Second current level 120 of resistor 100 includes at least one second current transport island 162. Each second current transport island 162 includes at least one of: base layer 142 of plurality of semiconductor layers 140 and a portion of doped conductive layer 132 (in trench 170) in base layer 142 of plurality of III-V semiconductor layers 140. As described, first current transport island(s) 164 may be further defined by a dopant (nitrogen implant) region 160 at least partially in first current level 110 in the plurality III-V semiconductor layers 140. Further, second current transport island(s) 162 may be further defined by dopant (nitrogen implant) region 160 at least partially in base layer 142 of the plurality of III-V semiconductor layers 140.

Referring again to FIGS. 1-3 and 10-12, resistor 100 can be configured to have any length current path (dark, heavy arrows) to control the overall resistance provided thereby. The different parts of resistor 100 are made of different materials that have different sheet resistances. More particularly, a length of the different parts of resistor 100 with their different sheet resistances can be selected to provide a desired resistance for resistor 100. For example, 2DEG region 158 formed within an interface of barrier layer 148 of aluminum gallium nitride and channel layer 146 of gallium nitride has a sheet resistance of 290-310 ohm per square nanometer (ohm/sq nm). Where doped conductive layer 132 is made of indium gallium nitride, it has a sheet resistance of 75-100 ohm/sq nm. Where base layer 142 includes intrinsic gallium nitride, it has a sheet resistance of 50-100 ohm/sq nm. Other materials may provide different sheet resistance. In any event, the lengths of the different parts can be selected to provide the desired resistance for resistor 100.

As shown in FIGS. 1-3, first current transport island(s) 164 may include a plurality of first current transport islands 164 and second current transport island(s) 162 may include a plurality of second current transport islands 162. The number and size of each current transport island 162, 164 can be selected to provide the desired overall resistance for resistor 100. As shown in FIGS. 2 and 3, each first current transport island 164 is coupled to at least one second current transport island 162 by doped conductive layer 132 of respective vertical interconnect resistor 130 and each second current transport island 162 is coupled to at least one first current transport island 164 by doped conductive layer 132 of a respective vertical interconnect resistor 130. As shown in FIG. 1, each first current transport island 164 may extend in a first direction (e.g., sideways on page of FIG. 1) and each second current transport island 162 may extend in a second direction perpendicular to the first direction (e.g., vertically on page of FIG. 1). In this manner, the plurality of first current transport islands 164, the plurality of second current transport islands 162 and the vertical interconnect resistors 130 coupled therebetween can be arranged in a lateral serpentine fashion, as observed in FIG. 1, and a vertical serpentine fashion, as observed in FIGS. 2 and 3. The length of the serpentine arrangement can be selected to create the desired overall resistance for resistor 100. The serpentine arrangement reduces the areal footprint required for resistor 100.

The arrangement of current transport islands 162, 164 and directions of current flow therein can also be arranged to control resistance of resistor 100. For example, in certain embodiments, as shown in FIG. 12, a current path through first current transport level 110 may overlap a current path through second current transport level 120. Here, the first current transport island 164 on the right extends away from the other first current transfer island 164 on the left to extend a length of that island and resistor 100 to increase a resistance of resistor 100.

In certain embodiments, as shown in FIGS. 9A-B, resistor 100 may include dielectric layer 176 between doped conductive layer 132 and the plurality of III-V semiconductor layers 140. As described, an upper end of dielectric layer 176 is below 2DEG region 158, so doped conductive layer 132 contacts 2DEG region 158.

While resistor 100 has been described herein relative to an n-type resistor, it will be recognized that the doping types can be reversed to form a p-type resistor 100. For example, p-type resistors can be made with p-type doped gallium nitride layer (not shown) over an aluminum gallium nitride barrier layer 148 and gallium nitride channel layer 146, a p-type doped trench vertical interconnect resistor 130, and a p-type doped (e.g., magnesium) intrinsic gallium nitride base layer 142.

Embodiments of the disclosure provide various technical and commercial advantages, examples of which are discussed herein. The resistor can be employed with III-V semiconductor devices such as HEMTs and/or MISHEMTs and possibly other transistor devices. Yet, the resistor provides areal size reduction by utilizing resistance distributed across two different current transport levels. Where a vertical device is being built, such as a light emitting diode (LED) or a vertical heterojunction bipolar transistor (HBT), the resistor can be built without additional processing steps.

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).
The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.
In summary, a resistor including a first current transport level, a second current transport level, and a vertical interconnect resistor that couples the first and second current transport levels is provided. The vertical interconnect resistor includes a doped conductive layer including one of indium gallium nitride (InGaN) and a doped polysilicon. The first and second current levels may include a number of current level islands that can be coupled in a lateral serpentine fashion and a vertical serpentine fashion to control a length and resistance value of the resistor. The resistor can be employed with III-V semiconductor devices and takes up less areal space than current resistors.

The following embodiments are explicitly disclosed.
Embodiment 1:
   A resistor, comprising:
   a first current transport level;
   a second current transport level; and
   a vertical interconnect resistor that couples the first and second current transport levels, the vertical interconnect resistor including a doped conductive layer including one of indium gallium nitride (InGaN) and a doped polysilicon.
Embodiment 2:
   The resistor of embodiment 1, wherein:
   the first current transport level includes at least one first current transport island, each first current transport island including one of: a two-dimensional electron gas (2DEG) region at an interface between a barrier layer and a channel layer of a plurality of III-V semiconductor layers and a portion of the doped conductive layer over the channel layer; and
   the second current level includes at least one second current transport island, each second current transport island including one of a base layer of the plurality of semiconductor layers and a portion of the doped conductive layer in the base layer of the plurality of III-V semiconductor layers.
Embodiment 3:
   The resistor of embodiment 2, wherein the at least one first current transport island includes at least two laterally isolated first current transport islands coupled to the second current transport level by the doped conductive layer of the vertical interconnect resistor.
Embodiment 4:
   The resistor of embodiment 2 or 3, wherein the at least one first current transport island includes a plurality of first current transport islands and the at least one second current transport island includes a plurality of second current transport islands, wherein each first current transport island is coupled to at least one second current transport island by the doped conductive layer of a respective vertical interconnect resistor and each second current transport island is coupled to at least one first current transport island by the doped conductive layer of a respective vertical interconnect resistor.
Embodiment 5:
   The resistor of embodiment 4, wherein each first current transport island extends in a first direction and each second current transport island extends in a second direction perpendicular to the first direction, wherein the plurality of first current transport islands, the plurality of second current transport islands and the vertical interconnect resistors coupled therebetween are arranged in a lateral serpentine fashion and a vertical serpentine fashion.
Embodiment 6:
   The resistor of one of embodiments 2 to 5, wherein each first current transport island is defined by a nitrogen implant region at least partially in the first current level in the plurality III-V semiconductor layers and each second current transport island is defined by a nitrogen implant region at least partially in the base layer of the plurality of III-V semiconductor layers.
Embodiment 7:
   The resistor of one of embodiments 2 to 6, wherein the barrier layer includes aluminum gallium nitride and the channel layer includes gallium nitride.
Embodiment 8:
   The resistor of one of embodiments 2 to 7, wherein the base layer includes one of an intrinsic III-V semiconductor and a III-V semiconductor doped with at least one of silicon and silicon germanium.
Embodiment 9:
   The resistor of one of embodiments 2 to 8, wherein the doped conductive layer extends vertically along a sidewall of a trench extending through the plurality of III-V semiconductor layers.
Embodiment 10:
   The resistor of embodiment 9, further comprising a dielectric layer between the doped conductive layer and the plurality of III-V semiconductor layers, wherein an upper end of the dielectric layer is below the 2DEG region.
Embodiment 11:
   The resistor of embodiment 9 or 10, wherein a bottom portion of the doped conductive layer in the trench is below and an upper surface of the base layer of the plurality of III-V semiconductor layers.
Embodiment 12:
   The resistor of one of embodiments 1 to 11, wherein the second current level includes at least one of an intrinsic III-V semiconductor, a doped III-V semiconductor and a portion of the doped conductive layer.
Embodiment 13:
   The resistor of one of embodiments 1 to 12, wherein a current path through the first current transport level overlaps a current path through the second current transport level.
Embodiment 14:
   A resistor, comprising:
   a first current transport level;
   a second current transport level; and
   a vertical interconnect resistor that couples the first and second current transport levels, the vertical interconnect resistor including a doped conductive layer including one of indium gallium nitride (InGaN) and a doped polysilicon,
   wherein the first current transport level includes a plurality of first current transport islands, each first current transport island including one of: a two-dimensional electron gas (2DEG) region at an interface between a barrier layer and a channel layer of a plurality of III-V semiconductor layers and a portion of the doped conductive layer over the channel layer, and wherein each first current transport island extends in a first direction,
   wherein the second current level includes a plurality of second current transport islands, each second current transport island including one of a base layer of the plurality of III-V semiconductor layers and a portion of the doped conductive layer in the base layer of the plurality of III-V semiconductor layers, and
   wherein each first current transport island is coupled to at least one second current transport island by the doped conductive layer of a respective vertical interconnect resistor and each second current transport island is coupled to at least one first current transport island by the doped conductive layer of a respective vertical interconnect resistor, and wherein each second current transport island extends in a second direction perpendicular to the first direction,
   wherein the plurality of first current transport islands, the plurality of second current transport islands and the vertical interconnect resistors coupled therebetween are arranged in a lateral serpentine fashion and a vertical serpentine fashion.
Embodiment 15:
   The resistor of embodiment 14, wherein each first current transport island is defined by a nitrogen implant region at least partially in the first current level in the plurality III-V semiconductor layers and each second current transport island is defined by a nitrogen implant region at least partially in the base layer of the plurality of III-V semiconductor layers.
Embodiment 16:
   The resistor of embodiment 14 or 15, wherein a current path through the first current transport level overlaps a current path through the second current transport level.
Embodiment 17:
   A method, comprising:
   forming a first current transport level;
   forming a second current transport level at a different level than the first current level; and
   forming a vertically interconnect resistor connecting the first current transport level to the second current transport level using a doped conductive layer including one of an indium gallium nitride (InGaN) and a doped polysilicon.
Embodiment 18:
   The method of embodiment 17, wherein forming the first and second current transport levels includes:
   forming a plurality of III-V semiconductor layers including a base layer, a channel layer over the base layer, and a barrier layer over the channel layer, wherein a two-dimensional electron gas (2DEG) region is at an interface between the barrier layer and the channel layer;
   forming a pair of spaced first current transport islands for the first current transport level, at least one of the first current transport islands including a portion of the 2DEG region;
   forming the second current level by implanting a current blocking dopant into at least the base layer to define a second current transport island in the base layer;
   wherein forming the vertical interconnect resistor using the doped conductive layer includes:
      forming a trench to the second current transport island; and
      epitaxially growing the doped conductive layer in the trench.
Embodiment 19:
   The method of embodiment 18, wherein forming the pair of spaced first current transport islands for the first current transport level includes forming the at least one of the first current transport island including the portion of the 2DEG region and forming at least one other of the pair of first current transport islands as a portion of the doped conductive layer over the channel layer.
Embodiment 20:
   The method of embodiment 18 or 19, further comprising forming a dielectric layer on sidewalls of the trench below the 2DEG region prior to epitaxially growing the doped conductive layer.
Embodiment 21:
   The method of one of embodiments 17 to 20, wherein the resistor of one of embodiments 1 to 16 is formed.

## Claims

1. A resistor, comprising:
a first current transport level;
a second current transport level; and
a vertical interconnect resistor that couples the first and second current transport levels, the vertical interconnect resistor including a doped conductive layer including one of indium gallium nitride (InGaN) and a doped polysilicon.

2. The resistor of claim 1, wherein:
the first current transport level includes at least one first current transport island, each first current transport island including one of: a two-dimensional electron gas (2DEG) region at an interface between a barrier layer and a channel layer of a plurality of III-V semiconductor layers and a portion of the doped conductive layer over the channel layer; and
the second current level includes at least one second current transport island, each second current transport island including one of a base layer of the plurality of semiconductor layers and a portion of the doped conductive layer in the base layer of the plurality of III-V semiconductor layers.

3. The resistor of claim 2, wherein the at least one first current transport island includes at least two laterally isolated first current transport islands coupled to the second current transport level by the doped conductive layer of the vertical interconnect resistor.

4. The resistor of claim 2 or 3, wherein the at least one first current transport island includes a plurality of first current transport islands and the at least one second current transport island includes a plurality of second current transport islands, wherein each first current transport island is coupled to at least one second current transport island by the doped conductive layer of a respective vertical interconnect resistor and each second current transport island is coupled to at least one first current transport island by the doped conductive layer of a respective vertical interconnect resistor.

5. The resistor of claim 4, wherein each first current transport island extends in a first direction and each second current transport island extends in a second direction perpendicular to the first direction, wherein the plurality of first current transport islands, the plurality of second current transport islands and the vertical interconnect resistors coupled therebetween are arranged in a lateral serpentine fashion and a vertical serpentine fashion.

6. The resistor of one of claims 2 to 5, wherein the barrier layer includes aluminum gallium nitride and the channel layer includes gallium nitride, and/or
wherein the base layer includes one of an intrinsic III-V semiconductor and a III-V semiconductor doped with at least one of silicon and silicon germanium, and/or
wherein the doped conductive layer extends vertically along a sidewall of a trench extending through the plurality of III-V semiconductor layers, and/or
wherein each first current transport island is defined by a nitrogen implant region at least partially in the first current level in the plurality III-V semiconductor layers and each second current transport island is defined by a nitrogen implant region at least partially in the base layer of the plurality of III-V semiconductor layers.

7. The resistor of one of claims 2 to 6, wherein the doped conductive layer extends vertically along a sidewall of a trench extending through the plurality of III-V semiconductor layers.

8. The resistor of claim 7, wherein the resistor further comprises a dielectric layer between the doped conductive layer and the plurality of III-V semiconductor layers, wherein an upper end of the dielectric layer is below the 2DEG region, and/or
wherein a bottom portion of the doped conductive layer in the trench is below and an upper surface of the base layer of the plurality of III-V semiconductor layers.

9. The resistor of one of claims 1 to 8, wherein the second current level includes at least one of an intrinsic III-V semiconductor, a doped III-V semiconductor and a portion of the doped conductive layer.

10. The resistor of one of claims 1 to 9, wherein a current path through the first current transport level overlaps a current path through the second current transport level.

11. The resistor of one of claims 1 to 10, wherein the first current transport level includes a plurality of first current transport islands, each first current transport island including one of: a two-dimensional electron gas (2DEG) region at an interface between a barrier layer and a channel layer of a plurality of III-V semiconductor layers and a portion of the doped conductive layer over the channel layer, and wherein each first current transport island extends in a first direction,
wherein the second current level includes a plurality of second current transport islands, each second current transport island including one of a base layer of the plurality of III-V semiconductor layers and a portion of the doped conductive layer in the base layer of the plurality of III-V semiconductor layers, and
wherein each first current transport island is coupled to at least one second current transport island by the doped conductive layer of a respective vertical interconnect resistor and each second current transport island is coupled to at least one first current transport island by the doped conductive layer of a respective vertical interconnect resistor, and wherein each second current transport island extends in a second direction perpendicular to the first direction,
wherein the plurality of first current transport islands, the plurality of second current transport islands and the vertical interconnect resistors coupled therebetween are arranged in a lateral serpentine fashion and a vertical serpentine fashion.

12. A method, comprising:
forming a first current transport level;
forming a second current transport level at a different level than the first current level; and
forming a vertically interconnect resistor connecting the first current transport level to the second current transport level using a doped conductive layer including one of an indium gallium nitride (InGaN) and a doped polysilicon.

13. The method of claim 12, wherein forming the first and second current transport levels includes:
forming a plurality of III-V semiconductor layers including a base layer, a channel layer over the base layer, and a barrier layer over the channel layer, wherein a two-dimensional electron gas (2DEG) region is at an interface between the barrier layer and the channel layer;
forming a pair of spaced first current transport islands for the first current transport level, at least one of the first current transport islands including a portion of the 2DEG region;
forming the second current level by implanting a current blocking dopant into at least the base layer to define a second current transport island in the base layer;
wherein forming the vertical interconnect resistor using the doped conductive layer includes:
forming a trench to the second current transport island; and
epitaxially growing the doped conductive layer in the trench.

14. The method of claim 13, wherein forming the pair of spaced first current transport islands for the first current transport level includes forming the at least one of the first current transport island including the portion of the 2DEG region and forming at least one other of the pair of first current transport islands as a portion of the doped conductive layer over the channel layer.

15. The method of one of claim 13 or 14, further comprising forming a dielectric layer on sidewalls of the trench below the 2DEG region prior to epitaxially growing the doped conductive layer.
